## Europäisches Patentamt
## European Patent Office
## Office européen des brevets

(19)

(11) Veröffentlichungsnummer: **0 054 157**
**B1**

(12) **EUROPÄISCHE PATENTSCHRIFT**

(45) Veröffentlichungstag der Patentschrift:
02.10.85

(51) Int. Cl.⁴: **H 01 L 31/02**

(21) Anmeldenummer: **81109042.2**

(22) Anmeldetag: **27.10.81**

(54) **Solarzelle mit erhöhtem Wirkungsgrad.**

(30) Priorität: **16.12.80 DE 3047383**

(43) Veröffentlichungstag der Anmeldung:
**23.06.82 Patentblatt 82/25**

(45) Bekanntmachung des Hinweises auf die Patenterteilung:
**02.10.85 Patentblatt 85/40**

(84) Benannte Vertragsstaaten:
**FR GB IT**

(56) Entgegenhaltungen:
**US - A - 3 310 439**
**US - A - 3 969 746**

**SOLID-STATE ELECTRONICS, Band 18, 1975, Oxford, P. SHAH "Analysis of vertical multijunction solar cells using a distributed circuit model", Seiten 1099 bis 1106**

(73) Patentinhaber: **Siemens Aktiengesellschaft, Berlin und München Wittelsbacherplatz 2, D-8000 München 2 (DE)**

(72) Erfinder: **Weyrich, Claus, Dr., Untertaxetweg 14, D-8035 Gauting (DE)**

**Beschreibung**

Die vorliegende Erfindung bezieht sich auf eine Solarzelle, wie sie im Oberbegriff des Patentanspruchs 1 angegeben ist.

Zum Stand der Technik gehörig ist ein Vorschlag, anstelle einer Solarzelle mit einem ebenflächigen pn-Übergang, dessen Ebene im wesentlichen senkrecht zur einfallenden Sonnenstrahlung auszurichten ist, einen solchen pn-Übergang im Halbleiterkörper der Solarzelle vorzusehen, der eine Rippen- und/oder Wabenstruktur hat. Die Rippen bzw. Waben erstrecken sich dabei parallel zur einfallenden Sonnenstrahlung in den Halbleiterkörper hinein. Eine Beschreibung dieses Vorschlags findet sich in Hovel, »Solar Cells«, S. 139 ff. in Semiconductor u. Semimetals, Ed. Willardson, BEER Academ. Press 1975. Um eine Solarzelle unempfindlich gegen zerstörenden Einfluß kosmischer Strahlung und dergl. zu machen und sie als langlebige Solarzelle für Raumfahrt-Experimente verwenden zu können, ist in »Fourteenth IEEE Photovoltaic Specialists Conference — 1980«, Jan. 7—10, San Diego, Calif., S. 151—155, eine Halbleiterstruktur beschrieben, die im Querschnitt wie ein Kamm mit breiten Zinken und dazu vergleichsweise sehr schmalen Zwischenräumen aussieht. Hergestellt sind diese Zwischenräume dadurch, daß man einen einkristallinen Halbleiterwafer in anisotroper Weise geätzt hat, und zwar derart, daß in der Oberfläche dieses Halbleiterwafers tiefe Rinnen in gleichmäßigen Abständen voneinander entstehen, wobei diese tiefen Rinnen schmal gegenüber den Abständen benachbarter Rinnen voneinander sind. Bei einkristallinem Material sind solche vergleichsweise zu ihrer Breite tiefe Rinnen mit Hilfe anisotropen Ätzens tatsächlich herstellbar. Die Oberfläche der Rinnen sowie die Oberfläche des zwischen den benachbarten Rinnen jeweils befindlichen Halbleitermaterials sind als eine p- oder n-Schicht ausgebildet und das darunterliegende Material ist ein n- oder p-leitendes Material, so daß ein oberflächennaher pn-Übergang vorliegt. Der entstandene Halbleiterkörper hat damit eine Oberfläche vergleichbar mit der eines Profil-Rippenbleches. Fig. 1 der obengenannten Druckschrift zeigt einen solchen durch anisotropes Ätzen bearbeiteten Einkristall-Halbleiterkörper.

Es ist eine Aufgabe der vorliegenden Erfindung, eine Solarzellen-Struktur anzugeben, die sehr preiswert herzustellen ist und die dennoch eine hohe Empfindlichkeit bzw. großen Wirkungsgrad der Umsetzung einfallender Solarstrahlung in erzeugte elektrische Energie hat.

Insbesondere soll diese neue Anordnung in einfacher Weise kontaktierbar sein.

Diese Aufgabe wird mit einer Solarzelle nach dem Oberbegriff des Patentanspruchs 1 erfindungsgemäß mit den Merkmalen dieses Patentanspruchs 1 gelöst. Weitere Ausgestaltungen und Weiterbildungen der Erfindung gehen aus den Unteransprüchen hervor.

Die Erfindung beruht auf der in anderem Zusammenhang an sich bekannten Überlegung, im Gegensatz zu einer Solarzelle mit eben-flächigem pn-Übergang einen solchen Solarzellen-Halbleiterkörper zu verwenden, der ein vergleichsweise sehr viel größeres, für die Umsetzung von Solarstrahlung in elektrische Energie wirksames Volumen hat, d. h. ein größeres Volumen hat, in dem absorbierte Solarstrahlung auch tatsächlich in verfügbare elektrische Energie umgewandelt wird. Bekanntermaßen ist für die Erzeugung elektrischer Energie ein nur relativ dünner Schichtanteil entlang der Fläche des pn-Übergangs wirksam, weil außerhalb dieses dem pn-Übergang nahen Schichtanteils erzeugte Ladungsträgerpaare nicht mehr elektrisch wirksam werden, nämlich weil die im jeweiligen Halbleitermaterial erzeugten Minoritätsträger nicht mehr in den Bereich des pn-Halbleiters durch Diffusion gelangen können.

Weitere Erläuterungen der Erfindung gehen anhand der Figuren gegebenen Beschreibung hervor.

Fig. 1 zeigt eine Schnittdarstellung eines Anteils einer erfindungsgemäßen Solarzelle.

Fig. 2 zeigt eine Aufsicht zur Fig. 1 mit Angabe des Schnitts.

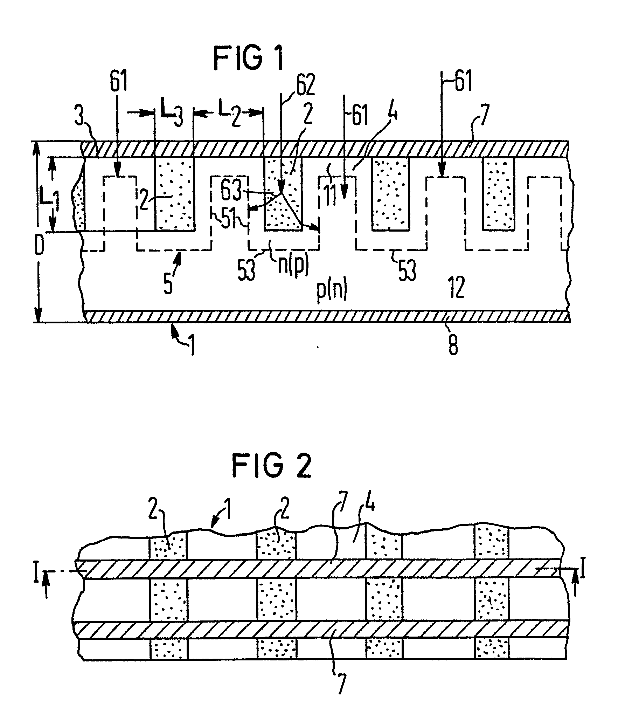

Die Querschnitt-Seitenansicht der Fig. 1 zeigt mit 1 bezeichnet einen Körper aus Halbleitermaterial, das bei der Erfindung insbesondere polykristallines Material sein kann. Mit 2 sind Einschnitte bzw. Rinnen in diesem Halbleiterkörper bezeichnet, die z. B. mit einer Säge-Vorrichtung ausgeführt worden sind und sich von der in der Fig. 1 oberen Oberfläche 3 des Halbleiterkörpers 1 her in diesen hinein erstrecken. Mit L1 ist die Einschnitt-Tiefe der durch den Sägeschnitt gebildeten Rinne 2 bezeichnet. Die Größe L1 kann z. B. bis zu 50% oder gar bis zu 75% der gesamten Dicke D des Halbleiterkörpers 1 betragen. Mit L2 ist der Abstand benachbarter Rinnen voneinander bemessen; dieser Wert entspricht der obengenannten Breite einer Rippe der Kammstruktur. Mit L3 ist, wie ersichtlich, der Zwischenraum zwischen den Wänden benachbarter Rippen 4 bezeichnet. Vorzugsweise ist diese Streifenstruktur äquidistant periodisch ausgeführt und bemessen. Mit 5 ist der Verlauf des pn-Übergangs im Halbleitermaterial kenntlich gemacht, wobei das Material 12 unterhalb des gestrichelt dargestellten Übergangs z. B. p-Material und das Material 11 darüber entsprechend n-Material (oder auch umgekehrt) ist.

Zum besseren Verständnis der Darstellung der Fig. 1 ist mit der Fig. 2 noch ein Ausschnitt der Aufsicht eines Halbleiterkörpers 1 wiedergegeben. Zur Fig. 1 bereits beschriebene Einzelheiten haben in Fig. 2 dieselben Bezugszeichen. Aus Fig. 2 ist insbesondere die Streifenstruktur der Einschnitte bzw. Rinnen 2 im Material des Halbleiterkörpers 1 zu erkennen. Mit 7 und 8 sind Streifenkontakte bezeichnet, die auf der Oberfläche 3 des Halbleiterkörpers 1 aufgebrachte Metallstreifen sind, die zusammen einen großflächig wirksamen elektrischen Anschluß für das Halbleitermaterial 11 oberhalb des pn-Übergangs 5 sind. Die Streifenelektroden 7 sind am Rande zu einem gemeinsamen Anschluß zusammengefaßt. Anstelle von Streifenelektroden 7 kann auch eine strahlungsdurchlässige ganzflächige Elektrode verwendet werden. Streifenelektroden sind aber weniger aufwendig und ihr Nachteil, einen geringen Flächenanteil der Oberfläche 3 des Halbleiterkörpers 1 gegen einfallende Sonnenstrahlung abzudecken, ist vernachlässigbar.

Mit 8 ist der zweite Kontakt am Halbleiterkörper 1 bezeichnet, der eine rückseitige Metallisierungsbelegung desselben ist. Da die Rückseite für Sonneneinstrahlung nicht vorgesehen ist, kann diese Elektrode 8 eine ganzflächige Metallbelegung sein.

Mit den Pfeilen 61 ist in Fig. 1 solche Solarstrahlung bezeichnet, die auf Flächenanteile der stehengebliebenen Rippen 4 des Halbleiterkörpers 1 fällt. In die Rinnen bzw. Zwischenräume 2 zwischen diesen Rippen 4 einfallende Solarstrahlung ist mit 62 bezeichnet. Wesentliches Merkmal der Erfindung ist nun, daß diese Zwischenräume 2 im Halbleiterkörper 1 mit einem die Solarstrahlung stark streuenden, diese aber möglichst wenig absorbierenden Material ausgefüllt sind. Dies kann ein Kunststoff, wie z. B. Epoxidharz, sein, der mit die Solarstrahlung streuenden Partikeln, wie z. B. kleine Metalloxidteilchen, z. B. $TiO_2$, gefüllt ist. Es kann hierfür eine solche Materialkombination verwendet werden, wie sie für LED-Anzeigen in anderem Zusammenhang und in anderer Funktion bekannt sind. Für die Größe dieser Teilchen ist die sich aus der Gesetzmäßigkeit der Strahlungsstreuung ergebende Bemessung zu bevorzugen. In den Fig. 1 und 2 sind die in den Einschnitten bzw. Rinnen 2 im dort vorhandenen Kunststoffmaterial enthaltenen Partikel als wahllos verteilte Punkte kenntlich gemacht.

In Fig. 1 ist mit 63 solche Strahlung kenntlich gemacht, die durch Streuung an den erwähnten Partikeln im Kunststoffmaterial aus der Solarstrahlung 62 entsteht. Diese Strahlung 63 ist sozusagen lediglich in ihrer Richtung umgelenkte Primär-Solarstrahlung, die somit von der Seite her in solche Schichtanteile des pn-Übergangs gelangt, der in der Fig. 1 durch vertikal verlaufende Linienzüge 51 kenntlich gemacht ist.

Die tief im Innern des Halbleiterkörpers waagerecht verlaufenden Anteile des pn-Übergangs 5 sind mit der Bezeichnung 53 kenntlich gemacht. In die zu diesen waagerecht verlaufenden Anteilen 53 parallelen Schichtanteile des pn-Übergangs 5 eindringende restliche Primärstrahlung 62 erzeugt dort ebenfalls Ladungsträgerpaare, die ein Betrag zur gesamten umgesetzten elektrischen Solarenergie sind.

Ein wesentlicher Vorteil einer Anordnung der vorliegenden Erfindung ist, daß die ursprünglich ebene Oberfläche 3 des Halbleiterkörpers 1 insgesamt wiederhergestellt ist, wobei die durch das Einsägen bzw. Einschneiden der Rinnen 2 zunächst weggefallenen Halbleiteranteile nun mit Kunststoff so ausgefüllt sind, so daß sich wieder eine wenigstens nahezu ebene Oberfläche ergibt. Vorteilhaft ist dies für die Anbringung der Elektrodenstreifen 7, die ohne Gefahr einer Unterbrechung über die Oberfläche des Halbleiterkörpers 1 hinweg verlaufen können.

Voranstehend ist zum Ausführungsbeispiel der Erfindung davon gesprochen worden, die Rinnen 2 durch Sägen zu erzeugen. Anstelle des Sägens kann der Halbleiterkörper die entsprechende Struktur auch dadurch erhalten, daß man im entsprechenden Muster einen genügend energiereichen Laserstrahl auf die Halbleiter-Oberfläche 3 fallen läßt, der dann entsprechende Rinnen im Halbleitermaterial 1 erzeugt. Es kann auch Ätzen vorgesehen sein, soweit dies beim bevorzugten Fall polykristallinen Halbleitermaterials des Halbleiterkörpers 1 nicht auf zu große Schwierigkeiten stößt, nämlich genügend tiefe (L1), aber dennoch schmale (L3) Rinnen zu erreichen.

Eine bevorzugte Bemessung einer erfindungsgemäßen Ausführungsform ist die, bei der L1 größer als $\frac{1}{\alpha}$ ist, wobei $\alpha$ der Absorptionskoeffizient für den langwelligen Teil der vorgesehenen Solarstrahlung 61, 62 ist. Vorzugsweise wird die Größe L2 kleiner oder höchstens ungefähr gleich dem Doppelten der Summe von $L_N$ und $L_P$ gewählt ($L_2 < 2 (L_N + L_P)$). Mit $L_N$ und $L_P$ sind die Elektronen- und die Löcherdiffusionslänge des betreffenden Halbleitermaterials des Halbleiterkörpers 1 bezeichnet. Bei einer derartigen Bemessung werden noch alle innerhalb des Volumens der Rippen 4 durch die Solarstrahlung 61, 62 erzeugten Ladungsträger gesammelt. Die Größe L3, d. h. die Breite der Rinnen, sollte möglichst gering sein. Sie ist bei Verwendung einer Säge durch die Breite des Sägeblattes gegeben, die mindestens etwa 50 μm beträgt. Bei Herstellung der Rinnen mittels Laserstrahlung können kleinere Breiten L3 erzielt werden. Bei Verwendung einer Ätztechnik hängt die Rinnenbreite L3 von der Rinnentiefe L1 und von der eventuell vorhandenen Kristallorientierung ab. Die zu dem pn-Übergang 5 führende Dotierung des Halbleiterkörpers 1 kann durch Eindiffusion der entsprechenden Donatoren und/oder Akzeptoren (je nachdem ob n- oder p-Material in ursprünglich p- oder n-leitendem Halbleitermaterial) erzeugt werden.

Die erfindungsgemäße Anordnung gestattet eine optimale Ausnutzung der auffallenden Solarstrahlung im Volumen der Rippen 4. Bei Annahme senkrechter Inzidenz der Solarstrahlung 61, 62 wird somit mindestens ein Flächenanteil L2/(L2+L3) der erfindungsgemäßen Solarzelle genutzt, der durch die erfindungsgemäß vorgesehene Streuung des Anteils 62 der Solarstrahlung in dem in den Rinnen bzw. Zwischenräumen 2 befindlichen Kunststoffmaterial (das mit den streuenden Partikeln gefüllt ist) zusätzlich erhöht wird. Wie ersichtlich, erhält man mit dem Erfindungsgedanken eine vergleichsweise wesentlich vergrößerte Oberfläche des pn-Übergangs 5 (mit 51 und 53). Eine erfindungsgemäße Solarzelle läßt sich trotz dieses Vorteils mit nur wenig mehr technologischem Aufwand herstellen, der insbesondere bei automatischer Massenfertigung nicht mehr ins Gewicht fällt.

## Patentansprüche

1. Solarzelle mit einem Halbleiterkörper (1), dessen Oberfläche (3) eine Rippenstruktur hat und bei dem die Fläche (5) des im Halbleiterkörper enthaltenen pn-Übergangs im wesentlichen parallel zur Oberfläche der Rippenstruktur verläuft, gekennzeichnet dadurch, daß die Zwischenräume (2) zwischen den jeweils benachbarten Rippen (4) des Halbleiterkörpers (1) mit einem für die Solarstrahlung (62) möglichst gut durchlässigen Material ausgefüllt sind, wobei sich in diesem Material Partikel befinden, die die Solarstrahlung (62) in starkem Maße streuen.

2. Solarzelle nach Anspruch 1, gekennzeichnet dadurch, daß das die Zwischenräume (2) ausfüllende Material ein Kunststoffmaterial ist.

3. Solarzelle nach Anspruch 1, gekennzeichnet dadurch, daß das die Zwischenräume (2) ausfüllende Material ein mit TiO₂ versetztes Epoxidharz ist.

4. Solarzelle nach Anspruch 1, 2 oder 3, gekennzeichnet dadurch, daß das Material des Halbleiterkörpers (1) polykristallines Halbleitermaterial ist.

5. Solarzelle nach Anspruch 1, 2, 3 oder 4, gekennzeichnet dadurch, daß die Zwischenräume (2) im Halbleiterkörper (1) Sägeeinschnitte sind.

6. Solarzelle nach einem der Ansprüche 1, 2, 3 oder 4, gekennzeichnet dadurch, daß die Zwischenräume (2) durch Laserstrahl-Bearbeitung erzeugte Einschnitte sind.

7. Solarzelle nach einem der Ansprüche 1 bis 6, gekennzeichnet dadurch, daß die Tiefe $(L_1)$ der Zwischenräume (2) größer als der Wert $\frac{1}{\alpha}$ bemessen ist, worin $\alpha$ der Absorptionskoeffizient des Materials des Halbleiterkörpers (1) für den langwelligen Teil der Solarstrahlung (61, 62) ist.

8. Solarzelle nach einem der Ansprüche 1 bis 7, gekennzeichnet dadurch, daß die Breite $(L_2)$ der Rippen (4) kleiner oder höchstens gleich der zweifachen Summe aus der Diffusionslänge der Elektronen und der Diffusionslänge der Löcher im Material des Halbleiterkörpers (1) ist.

## Claims

1. A solar cell having a semiconductor body (1), the surface (3) of which has a ribbed structure and in which the face (5) of the pn-junction, contained in the semiconductor body, extends essentially parallel to the surface of the ribbed structure, characterised in that the interspaces (2) between adjacent ribs (4) of the semiconductor body (1) are filles with a material which is highly permeable to solar radiation (62), particles which scatter the solar radiation (62) to a large extent, being present in the material.

2. A solar cell as claimed in Claim 1, characterised in that the material which fills the interspaces (2) is a synthetic resin material.

3. A solar cell as claimed in Claim 1, characterised in that the material which fills the interspaces (2), is an epoxy resin mixed with TiO₂.

4. A solar cell as claimed in Claim 1, 2 or 3, characterised in that the material of the semiconductor body (1) is a polycrystalline semiconductor material.

5. A solar cell as claimed in Claim 1, 2, 3 or 4, characterised in that the interspaces (2) in the semiconductor body (1) are saw cuts.

6. A solar cell as claimed in one of Claims 1, 2, 3 or 4, characterised in that the interspaces (2) are incisions produced by laser beam treatment.

7. A solar cell as claimed in one of Claims 1 to 6, characterised in that the depth $(L_1)$ of the interspaces (2) is greater than the value $\frac{1}{\alpha}$, where $\alpha$ is the absorption coefficient of the material of the semiconductor body (1) for the long-wave component of the solar radiation (61, 62).

8. A solar cell as claimed in one of Claims 1 to 7, characterised in that the width $(L_2)$ of the ribs (4) is smaller than, or at most equal to, double the sum of the diffusion length of the electrons and the diffusion length of the holes in the material of the semiconductor body (1).

## Revendications

1. Pile solaire ayant un corps semiconducteur (1) dont la surface (3) a une structure à nervures et dans lequel la surface (5) de la transition pn contenue dans le corps semiconducteur s'étend sensiblement parallèlement à la surface de la structure à nervures, caractérisée en ce que le intervalles (2) entre les nervures (4) du corps semiconducteur (1) sont remplis d'un matériau aussi transparent que possible au rayonnement solaire (62), des particules, qui diffusent fortement le rayonnement solaire (62), se trouvant dans ce matériau.

2. Pile solaire suivant la revendication 1, caractérisée en ce que le matériau remplissant les intervalles (2) est une matière plastique.

3. Pile solaire suivant la revendication 1, caractérisée en ce que le matériau remplissant les intervalles (2) est une résine époxydique mélangée à du TiO₂.

4. Pile solaire suivant la revendication 1, 2 ou 3, caractérisée en ce que le matériau du corps semiconducteur est un matériau semiconducteur polycristallin.

5. Pile solaire suivant la revendication 1, 2, 3 ou 4, caractérisée en ce que les intervalles (2) dans le corps semiconducteur (1) sont des traits de scie.

6. Pile solaire suivant l'une des revendications 1, 2, 3 ou 4, caractérisée en ce que les intervalles (2) sont des entailles produites par usinage au moyen d'un faisceau laser.

7. Pile solaire suivant l'une des revendications 1 à 6, caractérisée en ce que la profondeur ($L_1$) des entailles (2) est supérieure à la valeur $\frac{1}{\alpha}$, $\alpha$ étant le coefficient d'absorption du matériau du corps semiconducteur (1) pour la partie de grande longueur d'onde du rayonnement solaire (61, 62).

8. Pile solaire suivant l'une des revendications 1 à 7, caractérisée en ce que la largeur ($L_2$) des nervures (4) est inférieure ou égale à deux fois la somme de la longueur de diffusion des électrons et de la longueur de diffusion des trous dans le matériau du corps semiconducteur (1).

# FIG 1

# FIG 2